# EUROPÄISCHE PATENTSCHRIFT

(11) **EP 3 447 785 B1**
(45) Veröffentlichungstag und Bekanntmachung des Hinweises auf die Patenterteilung: **26.08.2020**
(21) Anmeldenummer: 18191740.2
(22) Anmeldetag: 23.05.2016
(51) Int. Cl.: H01H 71/08, H02B 1/20, H01R 9/26, H01H 9/54, H01H 7/04, H01R 13/717, H01R 25/14, H02B 1/052, H01H 71/04, H05K 7/14

(54) **STROMVERTEILER**
CURRENT DISTRIBUTOR
DISTRIBUTEUR DE COURANT

(30) Priorität: 21.07.2015 DE 102015213744
(43) Veröffentlichungstag der Anmeldung: 27.02.2019
(62) Teilanmeldung aus: 16729203.6
(73) Patentinhaber: Ellenberger & Poensgen GmbH, 90518 Altdorf (DE)
(72) Erfinder: FISCHER, Erich, 90518 Altdorf (DE); WERNER, Klaus, 90552 Röthenbach (DE)
(74) Vertreter: FDST Patentanwälte

(56) Entgegenhaltungen:
- EP-A1- 0 534 538
- WO-A1-2015/103196
- DE-A1-102012 021 055
- FR-A1- 2 875 373

## Beschreibung

Die Erfindung betrifft einen modularen Stromverteiler für eine direkte Montage auf einer Trägerschiene, umfassend eine Anzahl an Stromverteilungsmodulen, insbesondere in Form eines Reiheneinbaugeräts.

Als Stromverteiler wird im Nachfolgenden insbesondere eine elektrische Installation mit einem oder mehreren elektrischen Laststromkreisen bezeichnet, denen aus einer gemeinsamen Hauptstromleitung Strom zugeführt ist. Im Rahmen des Stromverteilers sind Sicherungsmechanismen vorgesehen, die jeden Laststromkreis einzeln gegen eine Überlast und/oder gegen Kurzschluss absichern.

Die Sicherungsmechanismen sind insbesondere mechanische, elektronische oder mechatronische Schutzschalter, die zwischen einem Hauptstromkreis oder einer Einspeisung und den Laststromkreisen verschaltet sind. Die Schutzschalter sind oftmals durch flexible Leitungsdrähte an die Einspeisung und Last einzelverdrahtet. Dadurch ist die Montage eines derartigen Stromverteilers besonders arbeitsaufwändig. Weiterhin ist das durch einen derartigen Stromverteiler gebildete Schaltsystem aufgrund der Einzelverdrahtungen vergleichsweise unübersichtlich, was Reparaturen und nachträgliche Änderungen im Montagezustand des Stromverteilers nachteilig erschwert.

Um den Verschaltungsaufwand herkömmlicher Stromverteiler zu reduzieren, können sogenannte modulare Stromverteiler eingesetzt werden, die aus mehreren einzelnen und miteinander elektrisch leitfähig koppelbaren Stromverteilungsmodulen zusammengesetzt sind. Die Stromverteilungsmodule sind typischerweise als Reiheneinbaugeräte nebeneinander direkt auf einer Tragschiene (Hutschiene) montierbar und weisen einerseits Anschlüsse für die Einspeisung und für die Last auf, sowie andererseits mindestens einen sockelartigen Steckplatz zum dazwischenschalten eines Schutzschalters. Die aneinandergereihten Module sind typischerweise mittels einer mehrere Module überbrückenden Stromschiene optisch übersichtlich miteinander elektrisch leitfähig gekoppelt.

Im Rahmen eines solchen Stromverteilers sind derartige, mit Schutzschaltern bestückte Stromverteilungsmodule insbesondere an den Zweigstellen vorgesehen, an denen die Laststromkreise von der Hauptstromleitung abzweigen. Die Schutzschalter dienen hierbei dazu, den jeweils zugeordneten Laststromkreis im Bedarfsfall von der stromführenden Hauptstromleitung zu trennen.

Typischerweise werden bei einer Aneinanderreihung einzelner Stromverteilungsmodule interne Verdrahtungen für eine Signalisierung bereitgestellt. Die eingesetzten Schutzschalter weisen hierfür integrierte Signalkontakte (Öffner und Schließer) auf, die je nach Anwendung im Rahmen einer Einzel- oder Sammelsignalisierung verschaltet und von einem Schaltsignal betätigbar sind.

Derartige Stromverteiler sind nach dem derzeitigen Stand der Technik lediglich für einpolige oder einkanalige Schutzschalter ausgeführt. Für den Anschluss eines zwei- oder mehradrigen Laststromkreises müssen von daher zusätzliche externe Klemmen oder Potenzialverteiler zwischen zwei oder mehreren einkanalige Schutzschaltern verschalten werden. Dadurch entstehen ein zusätzlicher Verschaltungsaufwand sowie ein erhöhter Platzbedarf entlang der Trägerschiene beziehungsweise in einem Schaltkasten.

Aus der WO 2015/103196 A1 ist eine Schalteranordnung bekannt. welche eine Schalterplatine mit einer Sammelschiene und mit einem Schaltermodul mit einem leitungsseitigen Verbinder aufweist.

In der DE 10 2012 021 055 A1 ist ein Gehäuse für an einer Tragschiene anbringbare oder aneinander anreihbare Vorrichtungen offenbart, mittels dem die Vorrichtungen an der Tragschiene anbringbar sind. Das Gehäuse weist ein Gehäuseteil zur Festlegung von Koppelmodulen auf, wobei die Koppelmodule zum Koppeln von Energieversorgungsleitungen oder zum Koppeln von Signalleitungen zwischen zwei benachbart zueinander an der Tragschiene angeordneten Vorrichtungen festlegbar sind.

In der FR 2 875 373 A1 ist ein modulares Steuersystem für einen oder mehrere Verbraucher beschrieben. Das Steuersystem weist eine Basis mit einer Frontplatte auf, an welcher ein oder mehrere Module für elektrische Geräte lösbar befestigbar und elektrisch über Verdrahtungselemente verbindbar sind.

In der EP 0 534 538 A1 ist ein elektrisches Verteilgerät als Stromverteiler beschrieben, bei welchen steuerbare Schaltgeräte mit Energieverbindungselementen und mit Signalverbindungselementen vorgesehen sind. Die Signalverbindungselemente sind mit einem Leitungssystem zur Übertragung von Steuersignalen verbunden. Das Leitungssystem weist hierbei mindestens ein Leitermodul mit einem Leiter, und mit Kontaktelementen zur Kontaktierung an weitere Leiter auf.

Der Erfindung liegt die Aufgabe zugrunde, einen Stromverteiler anzugeben, der dazu geeignet und eingerichtet ist, mehrkanalige Laststromkreise unter einem möglichst geringen Verschaltungsaufwand mit einem mehrkanaligen Schutzschalter zu koppeln.

Bezüglich des Stromverteilers wird die genannte Aufgabe durch die Merkmale des Anspruchs 1 erfindungsgemäß gelöst. Vorteilhafte Weiterbildungen und Ausgestaltungen sind Gegenstand der Unteransprüche.

Der erfindungsgemäße Stromverteiler ist modular mit einer Anzahl von aneinandergereihten Stromverteilungsmodulen - nachfolgend verkürzt auch als Module bezeichnet - aufgebaut. Die einzelnen Module und somit der Stromverteiler sind zur direkten Montage auf einer Tragschiene, wie beispielsweise einer Hut- oder G-Schiene geeignet und eingerichtet. Die Module sind hierzu insbesondere nach Art eines Reiheneinbaugeräts in einer Reihe nebeneinander auf der Tragschiene montierbar. Das dadurch gebildete Modulpaket umfasst ein stirnseitig angeordnetes Einspeisemodul und ein auf der gegenüberliegenden Paketstirnseite angeordnetes Signalmodul sowie eine Anzahl an dazwischen angeordneten Anschlussmodulen.

Das Einspeisemodul ist in einer bevorzugten Einbausituation mit einem Einspeiseanschluss an eine Hauptstromzuführung oder Einspeisung elektrisch leitfähig gekoppelt. Das Anschlussmodul dient insbesondere zur Stromverteilung oder Abzweigung an einen mittels einer Zuführungsleitung gekoppelten Laststromkreis und ist vorzugsweise mit einem betätigbaren Schutzschalter bestückt oder bestückbar. Der Schutzschalter unterbricht den angeschlossenen Laststromkreis selbsttätig im Falle einer auftretenden Überlast oder eines Kurzschlusses.

Das Anschlussmodul weist vorzugsweise eine Anzahl an Lastanschlüssen zur Verdrahtung eines mehrkanaligen Laststromkreises auf. Mittels eines ersten Signalanschlusses des Signalmoduls ist ein die Schutzschalter betätigendes Schaltsignal einspeisbar. Zu diesem Zweck sind die Module untereinander geeigneterweise elektrisch leitfähig gekoppelt oder koppelbar. Dadurch ist ein Stromverteiler bereitgestellt, mit dem ein mehrkanaliger Laststromkreis unter einem geringen Verschaltungsaufwand anschließbar ist. Insbesondere ist der mehrkanalige Laststromkreis lediglich durch ein einzelnes Anschlussmodul mit einem bestückten und entsprechend mehrkanalig ausgeführten Schutzschalter an die Hauptstromleitung koppelbar.

Zur Führung eines Kommunikationssignals ist eine Kommunikationsleitung durch zweite Kontaktelemente realisiert. Die Kommunikationsleitung erstreckt sich hierzu vorzugsweise von einem ersten Kommunikationsanschluss des Einspeisemoduls über die Anschlussmodule, wo sie mittels des Kommunikationskontakts an die Steuereinheit des bestückten Schutzschalters gekoppelt ist. Die Kommunikationsleitung setzt sich fort bis ins Signalmodul, an dem das Kommunikationssignal mittels eines zweiten Kommunikationsanschlusses abgreifbar ist. Durch die Bereitstellung der Kommunikationsleitung ist die Anbindung busfähiger Schutzschalter sowie interner und externer Bussysteme ermöglicht. Dadurch ist der Stromverteiler zum Beispiel an eine externe Steuereinheit zum Zwecke einer übergeordneten Steuerungsanordnung, einer ferngesteuerte Betätigung der Schutzschalter und/oder zu einer Erfassung von Messwerten (beispielsweise dem durch die Schutzschalter fließenden Schaltsignal) sowie zu einer Diagnose im Fehlerfall geeignet und eingerichtet.

In einer besonders geeigneten Weiterbildungsform sind insbesondere zwei Kommunikationsleitungen für jeweils ein Kommunikationssignal für den Stromverteiler vorgesehen. Die erste Kommunikationsleitung dient insbesondere der Führung eines Datenbussignals, und die zweite Kommunikationsleitung zur Führung eines Adressbussignals. Dadurch ist es beispielsweise möglich die Schutzschalter von verschiedenen Laststromkreisen ferngesteuert zu schalten, zurückzusetzen, zu überwachen oder zu parametrisieren. Unter Parametrisierung ist in diesem Zusammenhang insbesondere das Einstellen von beispielsweise Auslöseschwellwerten und Steuer- oder Betriebsparametern, wie zum Beispiel dem Nennstrom des jeweiligen Schutzschalters, zu verstehen. Hierzu werden die Kommunikationssignale zweckmäßigerweise an die Steuereinheit des Schutzschalters versendet, die dazu geeignet und eingerichtet ist, derartige Signale zu verarbeiten und umzusetzen.

Die Module umfassen ein vorzugsweise flach ausgeführtes (Modul-)Gehäuse aus einem elektrisch isolierenden Material. Das Anschlussmodul ist in einer bevorzugten Einbausituation mit der Hauptstromzuführung oder Einspeisung zur Stromverteilung oder Abzweigung durch die Verschaltung der Module untereinander elektrisch leitfähig mit dem Einspeiseanschluss des Einspeisemoduls gekoppelt.

Bevorzugterweise weist das Anschlussmodul gehäusefrontseitig, das heißt auf der der Tragschiene abgewandten (Gehäuse-)Seite, einen sockelartigen Steckplatz zum Aufstecken des Schutzschalters auf. Mittels des Schutzschalters ist der angeschlossene Laststromkreis galvanisch unterbrechbar beziehungsweise auftrennbar. Die Steckverbindung zwischen dem Anschlussmodul und dem Schutzschalter ist beispielsweise mit Lamellen-, Bolzen-, oder bevorzugterweise mit Flachsteckern ausgeführt.

Die modulare Bauweise des Stromverteilers ermöglicht einen hohen Vorfertigungsgrad und dadurch vergleichsweise geringe Herstellungs- und Montagekosten. Insbesondere ist es möglich einen Stromverteiler durch eine Aneinanderreihung einer entsprechenden Anzahl an Anschlussmodulen besonders einfach an eine gewünschte Anzahl anzuschließender (mehrkanaliger) Laststromkreise anzupassen. Ungeachtet dessen ist es aber ebenso denkbar, ein oder mehrere Anschlussmodule im Rahmen einer signalisierungslosen Verdrahtung lediglich mit einem Einspeisemodul zu koppeln. Dadurch ist der Stromverteiler hinsichtlich einer elektrischen Anlage besonders flexibel einsetzbar.

Der Schutzschalter ist typischerweise als ein mechanischer, elektronischer oder mechatronischer Schalter oder als ein Relais ausgeführt, und weist üblicherweise einen Einspeisungsanschluss, über den eine netzseitige und somit stromführende Stromleitung durch einen ersten Steckkontakt mit dem Anschlussmodul angeschlossen wird, sowie einen Lastanschluss auf, über den die lastseitig abgehende Stromleitung durch einen zweiten Steckkontakt mit dem Anschlussmodul anschließbar ist.

Unter Schutzschalter sind insbesondere thermische, thermisch-magnetische und elektronische Geräteschutzschalter, Schaltrelais oder Überstromschutzgeräte zu verstehen, die eine interne Steuereinheit aufweisen. Die Steuereinheit ist insbesondere auch dazu eingerichtet, in Abhängigkeit des Schaltsignals ein Schaltelement des Schutzschalters zu betätigen. Hierzu weist der Schutzschalter vorzugsweise zwei mit der Steuereinheit verschaltete Signalkontakte (Öffner, Schließer) für den Steckplatz des Anschlussmoduls auf. Der Schutzschalter umfasst weiterhin mindestens einen Kommunikationskontakt zur Anbindung an eine Kommunikationsleitung, beispielsweise im Zuge einer Busverbindung für Signalkontaktfunktionen.

Die Schutzschalter sind in dem durch die Anschlussmodule vorgegebenen Rastermaß an dem Stromverteiler anbringbar beziehungsweise bestückbar. Die Anschlussmodule sind insbesondere etwa so breit wie die Schutzschalter, das heißt ein Anschlussmodul dient vorzugsweise der Aufnahme jeweils eines Schutzschalters. Vorzugsweise ist es hierbei möglich, die bestückten Schutzschalter des Stromverteilers sowohl in einer Reihenschaltung als auch einer Parallelschaltung zu betreiben, wobei hierfür optional zusätzliche Anschlüsse an einem oder mehreren Modulen vorgesehen sind.

Die Module weisen im Zuge der Ausgestaltung als Reiheneinbaugeräte vorzugsweise gehäuserückseitig eine profilierte Aufnahme (Aufrastnut) zum Aufsetzen des Stromverteilers auf die Tragschiene auf. Die Gehäusefrontseite ist somit in der vorgesehenen Einbausituation der Module einem Benutzer zugewandt. Die Profilrichtung der Aufnahme (und der mit dieser korrespondierenden Tragschiene) definiert eine Reihenrichtung, entlang derer mehrere Module in Montagezustand bestimmungsgemäß aneinander aufreihbar sind. Die zu dieser Reihenrichtung senkrecht orientierten Gehäuseseiten sind nachfolgend als (Gehäuse-)Stirnseiten bezeichnet. Die beiden übrigen Gehäuseseiten sind entsprechend der bestimmungsgemäßen Einbaustellung der Module als (Gehäuse-)Oberseite beziehungsweise (Gehäuse-)Unterseite bezeichnet.

In einer vorteilhaften Ausgestaltung weisen zumindest das Einspeisemodul und das Anschlussmodul jeweils einen Einspeisungsanschluss zur Zuführung des eingespeisten Stromes mit einem ersten Koppelkontakt, einen Masseanschluss mit einem zweiten Koppelkontakt sowie einen Rückführanschluss zur Rückführung des Stromes im Zuge einer Funktions- oder Schutzerde mit einem dritten Koppelkontakt auf. Der Massenanschluss dient hierbei bei einem Absichern eines Gleichspannungsnetzes als ein Minus-Anschluss, und bei einem Wechselspannungsnetz als Anschluss für den Neutralleiter. Die Koppelkontakte sind vorzugsweise in einem jeweils zugeordneten gehäusefrontseitigen Gehäuseschlitz angeordnet, der das jeweilige Gehäuse in Reihenrichtung vollständig durchsetzt. Werden mehrere Module aneinandergereiht, so fluchten die jeweiligen Gehäuseschlitze mit den zugehörigen Gehäuseschlitzen der jeweils anderen Module. Dies ermöglicht den Einsatz von als Profilteile ausgebildeten Stromschienen, die in die fluchtenden Gehäuseschlitze eingedrückt werden, und somit durch die Gehäuse berührungssicher abgeschirmt sind. Dadurch werden die Betriebspotentiale für alle aneinandergereihten Module bereitgestellt, und die Module untereinander in Quer- beziehungsweise Reihenrichtung miteinander elektrisch leitfähig gekoppelt, insbesondere parallel geschalten.

Derartige Stromschienen sind aus fertigungstechnischen Gründen sowie im Hinblick auf eine hohe mechanische Stabilität besonders vorteilhaft. Durch die fluchtende Anordnung der Koppelkontakte ist weiterhin sichergestellt, dass die Koppelkontakte der einzelnen Module jeweils mittels einer geraden Stromschiene überbrückbar sind, was aus fertigungstechnischen Gründen sowie im Sinne eines möglichst übersichtigen Schaltungsaufbaus besonders von Vorteil ist.

Durch die Anordnung der Gehäuseschlitze an den Modulvorderseiten wird eine besonders einfache Montage der Stromschienen ermöglicht, die insbesondere auch unter beengten Platzverhältnissen, beispielsweise in einem Schaltschrank vorzunehmen ist. Zudem sind die Stromschienen durch die Anordnung der Koppelkontakte auch dann noch sichtbar, wenn die Module in einem Schaltschrank eingebaut sind, was die Übersichtlichkeit einer mit dem Stromverteiler gekoppelten elektrischen Anlage fördert.

Die Gehäuseschlitze sind vorzugsweise derart dimensioniert, dass sie die jeweils zugeordneten Koppelkontakte fingersicher aufnehmen. Dies ermöglicht es insbesondere, ein Anschlussmodul in Einzelverdrahtung zu verwenden, ohne die Gehäuseschlitze aus Sicherheitsgründen abdecken zu müssen. Die fingersichere (berührungssichere) Ausbildung der Gehäuseschlitze ist insbesondere vorteilhaft, da die Gehäuseschlitze vorzugsweise an der in der Einbausituation einfach zugänglichen Gehäusefrontseite angeordnet sind.

In einer vorteilhaften Ausführung ist zur Führung des Schaltsignals eine durch die Module gebildete, und vorzugsweise insbesondere in den Modulen integrierte, Schaltsignalleitung bereitgestellt. Die Schaltsignalleitung ist eine im Wesentlichen interne Verdrahtung der Module zur Signalisierung und Betätigung der montierten Schutzschalter. Hierzu wird das Schaltsignal in einem zweiten Signalanschluss des Einspeisemoduls eingespeist und über das Anschlussmodul elektrisch leitfähig an die Signalkontakte des Schutzschalters, und somit der Steuereinheit, gekoppelt.

Die Verdrahtung der Schaltsignalleitung ist insbesondere derart durch die Module geführt, dass die bestückten Schutzschalter der Anschlussmodule hinsichtlich ihrer Signalanschlüsse miteinander in Reihe geschalten sind. Das Schaltsignal ist an dem ersten Signalanschluss des Signalmoduls zur Überwachung und Auswertung abgreifbar. Die Querverdrahtung der Module untereinander ist insbesondere mittels ersten Kontaktelementen bereitgestellt, wobei die Kontaktelemente im Montagezustand eine elektrisch leitfähige Kopplung in Reihenrichtung, das heißt von Gehäusestirnseite zu Gehäusestirnseite zwischen jeweils zwei benachbarten Modulen realisieren.

Durch die Schaltsignalleitung ist eine integrierte Signalleitung innerhalb der aneinandergereihten Module für eine Signalisierung und Betätigung der montierten (mehrkanaligen) Schutzschalter bereitgestellt. Das Schaltsignal ist beispielsweise als ein Signalstrom von einer speicherprogrammierten Steuerung (SPS) oder einem digitalen Eingang als Einzel- oder Sammelsignalisierung eingespeist, ebenso denkbar ist jedoch auch der Einsatz von einer Signalspannung. Dadurch entfällt beispielsweise die Notwendigkeit einer zusätzlichen Verdrahtung oder der Einsatz eines Backplane-Buses, was einer vereinfachten Montage und Verdrahtung des Stromverteilers zuträglich ist.

In einer vorteilhaften Ausgestaltung sind die ersten und zweiten Kontaktelemente mit einem seitlich aus dem Gehäuse herausragenden Federbügel ausgeführt, der im Montagezustand stirnseitig zumindest teilweise in ein benachbartes Gehäuse eingreift und mit einem Kontaktierbügel des benachbarten Kontaktelements elektrisch leitfähig koppelt. Die Kontaktierbügel sind hierzu vorzugsweise in einer stirnseitigen Gehäuseaufnahme oder -öffnung des jeweiligen Moduls angeordnet. Im Montagezustand ist somit eine elektrisch leitfähige Kopplung in Reihenrichtung, das heißt von Gehäusestirnseite zu Gehäusestirnseite zwischen den benachbarten Modulen bereitgestellt. Dadurch ist einerseits eine einfach lösbare Steck- oder Klemmkontaktierung entlang der Reihenrichtung bereitgestellt, was der Flexibilität und dem modularen Aufbau des Stromverteilungssystems zuträglich ist. Andererseits sind die Kontaktstellen der Kontaktelemente berührungssicher innerhalb der Gehäuse angeordnet und werden im Wesentlichen vollständig durch die stirnseitigen Gehäusewände der aneinandergereihten Module abgedeckt. Alternativ ist es aber ebenso denkbar, die Kontakteelemente nach Art einer Stecker-Buchsen-Verbindung, beispielsweise mit Flachsteckern, auszuführen.

Das Schaltsignal sowie die Kommunikationssignale sind typischerweise Niederstrom-/niederspannungssignale, sodass die Kontaktelemente insbesondere als Niederstromkontakte ausgeführt sind. Zum Erhalt eines möglichst geringen Übergangswiderstandes sind die Kontaktelemente vorzugsweise veredelt, beispielsweise vergoldet oder versilbert. Ebenso denkbar ist aber auch eine Ausführungsform mit Kontaktelementen aus einem Buntmetall, welches zum Zwecke einer verbesserten Kontaktkraft vorzugsweise verzinnt ausgeführt ist.

In einer besonders vorteilhaften und bevorzugten Ausführung ist das Anschlussmodul zur Aufnahme und Kontaktierung von sowohl einkanaligen als auch mehrkanaligen Schutzschaltern geeignet und eingerichtet. Hierzu weist das Anschlussmodul eine lastausgangsseitige Kontaktöffnung für einen Steckkontakt des Schutzschalters auf. Die Kontaktöffnung ist insbesondere als ein geteilter Stecksockelkontakt ausgeführt, wobei die dadurch gebildeten Stecksockelteilkontakte einerseits galvanisch voneinander getrennt und andererseits elektrisch leitfähig an jeweils einen separaten Lastanschluss gekoppelt sind. Der vorzugsweise als Flachstecker ausgeführte Steckkontakt weist hierbei zweckdienlicherweise eine der Anzahl der Schaltkanäle entsprechende Anzahl von Steckfahnen auf, die vorzugsweise mit einer entsprechenden Anzahl an Stecksockelteilkontakten verbunden werden. Durch die Teilung des Stecksockelkontakts ist das Anschlussmodul auf konstruktiv einfache und somit kostengünstige Art und Weise dazu geeignet und eingerichtet, einen mehrkanaligen Schutzschalter zum Beschalten eines mehrkanaligen Laststromkreises zu verwenden.

Die Anzahl der Teilungen entspricht hierbei zweckmäßigerweise mindestens der Anzahl der Stromkanäle oder -adern des Laststromkreises. Insbesondere ist aber auch weiterhin der Einsatz eines einpoligen Schutzschalters zur Beschaltung eines einadrigen Laststromkreises mit einem der mehrfach ausgeführten Lastanschlüssen ermöglicht. Weiterhin entfallen bei der Verschaltung von mehradrigen Laststromkreisen zusätzliche äußere Klemmen oder Potentialverteiler, wodurch einerseits der Verschaltungsaufwand vorteilhaft reduziert wird. Andererseits wird der Stromverteiler dadurch besonders platzsparend, wobei die vorzugsweise flachen Module sowie die Ausgestaltung als Reiheneinbaugeräte einer besonders kompakten Bauform des Stromverteilers zusätzlich zuträglich sind.

In einer geeigneten Ausbildung ist ein Anzeigemodul zur optischen Überwachung der Schaltsignalleitung an das Signalmodul anschließbar. Insbesondere weist das Anzeigemodul eine Anzeige-LED als optisches Anzeigeelement sowie eine das Schaltsignal verstärkende Zusatzbeschaltung auf. Dadurch ist es einem Benutzer ermöglicht, den Betriebszustand des Schaltsignalkreises durch einfache optische Inspektion der Anzeige-LED zu überprüfen. Alternativ ist es ebenso denkbar, dass das Anzeigemodul, beziehungsweise die Anzeige-LED sowie die Zusatzbeschaltung, bereits innerhalb des Signalmoduls integriert ist.

Die Anzeige-LED leuchtet beispielsweise im Betrieb, wenn die Schaltsignalleitung mit Strom durchflossen wird. Erlischt die Anzeige-LED, so ist dem Benutzer auf einfache Art und Weise vermittelt, dass eine Unterbrechung der Schaltsignalleitung vorliegt. Die verstärkende Zusatzbeschaltung ist in einer besonders einfachen Ausbildungsform beispielsweise durch eine Reihenschaltung eines Widerstands, der Anzeige-LED, einer Schutzdiode sowie gegebenenfalls eines Überspannungsschutzes ausgeführt.

In einer vorteilhaften Weiterbildung weist die Zusatzbeschaltung ein internes Netzteil als Spannungsversorgung und eine elektronische Auswerteeinheit auf, wobei die Anzeige-LED vorzugsweise mehrfarbig, insbesondere als eine Doppel-LED, ausgeführt ist. Durch die mehrfarbige LED ist durch eine geeignete Ansteuerung der Auswerteeinheit eine eindeutige Signalisierung des Schaltsignalkreis-Zustands für den Benutzer bereitgestellt. Das integrierte Netzteil stellt hierbei eine kurzschlussfeste, separate Versorgung der LED bereit, sodass auch bei einem Kurzschluss der Schaltsignalleitung ein optisches Signal an den Benutzer versendet und ein Ausfall oder Kurzschluss schnell und zuverlässig bemerkt werden kann.

Die Auswerteeinheit und die LED sind hierzu insbesondere zu einer Ampel-Anzeige gekoppelt, wobei die Auswerteeinheit dazu geeignet und eingerichtet ist, das Schaltsignal beispielsweise durch eine Strom- oder Spannungsmessung zu erfassen, und abhängig von dem erfassten Messwert die leuchtende Farbe der LED zu ändern. Die Doppel-LED wird vorzugsweise als Ampel-Anzeige beschaltet, die optisch die Zustände AUS, grün, gelb, und rot gegebenenfalls auch blinkend darstellen kann.

Die mit dem erfindungsgemäßen modularen Stromverteiler erzielten Vorteile bestehen insbesondere in dem modularen Aufbau sowie der Möglichkeit sowohl einkanalige als auch mehrkanalige Laststromkreise mit entsprechenden Schutzschaltern zu beschalten. Insbesondere ist pro Schutzschalter lediglich ein Anschlussmodul für den jeweiligen Laststromkreis notwendig, sodass der Stromverteiler besonders platzsparend ausgestaltet ist. Ferner sind einkanalige und mehrkanalige Laststromkreise gleichzeitig und mit lediglich einem Stromverteiler anschließbar. Ferner ist auch ein gekoppelter Signalbetrieb durch die Schaltsignalleitung für den gleichzeitigen Einsatz von ein- und mehrkanaligen Schutzschaltern realisiert.

Die Anschlussmöglichkeiten der Anschlussmodule ermöglichen den modularen und besonders flexiblen Aufbau eines Stromverteilungssystems mit thermischen, thermisch-magnetischen und elektronischen Geräteschutzschaltern, Schaltrelais oder mit elektronischen Sicherungsautomaten mit Signalkontakten. Diese können sowohl in einer klassischen Beschaltung der Schließerkontakte (Reihenschaltung) als auch in einer Beschaltung der Öffnerkontakte (Parallelschaltung) betrieben werden. Zusätzlich ist der Stromverteiler mit mindestens einer Kommunikationsschnittstelle (Datenbus und Adressbus) versehen, sodass die Anbindung von neuartigen, busfähigen Schutzschaltern und Geräten an interne und externe Bussysteme problemlos ermöglicht ist. Vorzugsweise wird im Betrieb des Stromverteilers ein Gerätebussystem zur ferngesteuerten Schaltung, Zurücksetzung, Überwachung, Parametrisierung etcetera angeschlossen. Ferner ist durch das an das Signalmodul bei Bedarf anschließbare Anzeigemodul auf konstruktiv einfache Weise eine optische Inspektion der Schutzschalter-Signalisierung bereitgestellt.

Nachfolgend werden Ausführungsbeispiele der Erfindung anhand einer Zeichnung näher erläutert. Es zeigen in vereinfachten und schematischen Darstellungen:
- Fig. 1: in perspektivischer Darstellung einen Stromverteiler mit einem Einspeisemodul, einem Signalmodul, sechs dazwischen angeordneten Anschlussmodule sowie zwei bestückte Schutzschalter,
- Fig. 2: in perspektivischer Darstellung das Einspeisemodul,
- Fig. 3: in perspektivischer Darstellung das Signalmodul,
- Fig. 4: in perspektivischer Darstellung ein Anschlussmodul,
- Fig. 5: in perspektivischer Darstellung ein Anschlussmodul ohne Gehäuse,
- Fig. 6a und 6b: in perspektivischer Darstellung einen geteilten Stecksockelkontakt des Anschlussmoduls mit einem gekoppelten Flachstecker eines Schutzschalters, für verschiedene Ausführungen des Flachsteckers,
- Fig. 7: einen Schaltplan für einen Stromverteiler mit einem Einspeisemodul, vier mit Schutzschaltern bestückten Anschlussmodulen und einem Signalmodul,
- Fig. 8: in perspektivischer Darstellung mit Blick auf die Oberseite zwei gekoppelte, gehäuselose Anschlussmodule mit jeweils drei Kontaktelementen,
- Fig. 9: in perspektivischer Darstellung die Kontaktelemente,
- Fig. 10: einen Schaltplan für ein mit dem Signalmodul koppelbares Anzeigemodul in einer ersten Ausführung, und
- Fig. 11: einen Schaltplan für ein mit dem Signalmodul koppelbares Anzeigemodul in einer zweiten Ausführung.

Einander entsprechende Teile sind in allen Figuren stets mit den gleichen Bezugszeichen versehen.

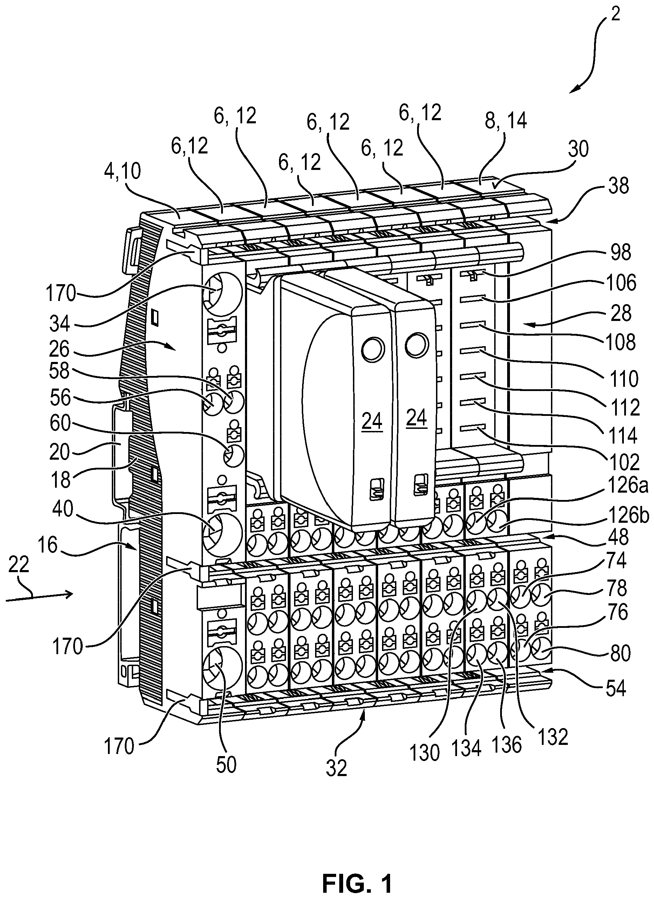

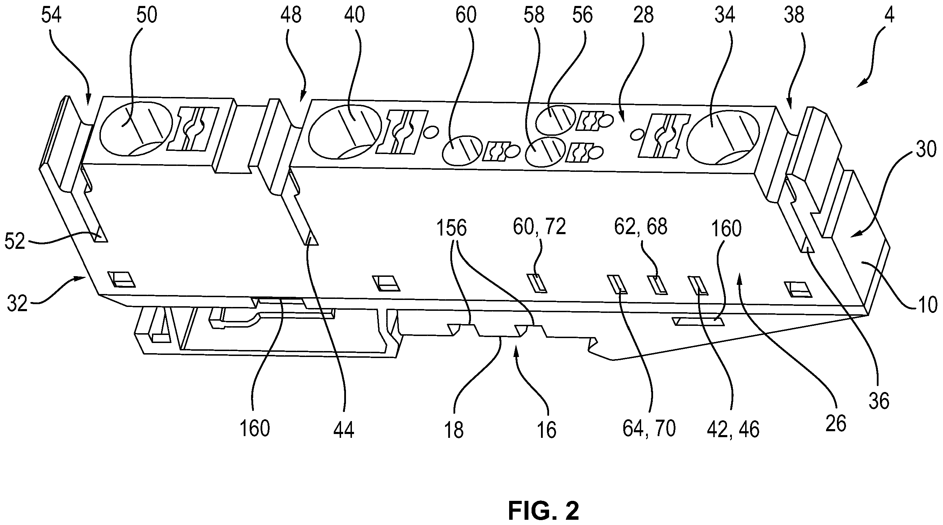

Der in Fig. 1 dargestellte Stromverteiler 2 umfasst ein Einspeisemodul 4, sechs Anschlussmodule 6 und ein Signalmodul 8 als (Stromverteilungs-)Module, die in den Figuren 2 bis 4 jeweils einzeln dargestellt sind. Jedes der Module 4, 6, 8 umfasst ein separates, das heißt von den anderen Modulen 4, 6, 8 getrenntes Gehäuse 10, 12 beziehungsweise 14. Jedes Modul 4, 6, 8 ist nach Art eines Reiheneinbaugeräts ausgebildet und weist dementsprechend an einer Gehäuserückseite 16 eine nutartige Aufnahme 18 auf, mit der das jeweilige Modul 4, 6, 8 zu Montagezwecken auf eine Tragschiene 20 aufschnappbar ist.

Die Profilrichtung dieser Aufnahme 18 - und entsprechend im Montagezustand auch die Profilrichtung der mit dieser Aufnahme 18 korrespondierenden Tragschiene 20 - definieren eine Reihenrichtung 22, entlang derer die Module 4, 6, 8 aneinander aufgereiht sind. In dem in Fig. 1 dargestellten Ausführungsbeispiel sind hierbei zwei Schutzschalter 24 an jeweils einem Anschlussmodul 6 im Inneren des aus den Modulen 4, 6, 8 gebildeten Pakets angeordnet, wobei das Einspeisemodul 4 einerseits und das Signalmodul 8 andererseits die Anschlussmodule 6 in Reihenrichtung 22 als Seitenteile außenseitig flankieren.

Die in Reihenrichtung 22 einander gegenüberliegenden Gehäuseflächen eines jeden Moduls 4, 6, 8 sind nachfolgend als Stirnseiten 26 des jeweiligen Moduls 4, 6, 8 bezeichnet. Die zu der Gehäuserückseite 16 entgegengesetzte Gehäuseseite eines jeden Moduls 4, 6, 8 ist als Frontseite 28 des Moduls 4, 6, 8 bezeichnet. Diese Frontseite 28 ist, wenn der Stromverteiler 2 in einem Schaltschrank montiert ist, einem Benutzer zugewandt. Die beiden übrigen Gehäuseseiten eines jeden Moduls 4, 6, 8 sind - entsprechend der konventionsgemäßen Einbaustellung des Moduls 4, 6, 8 - als Oberseite 30 beziehungsweise Unterseite 32 unabhängig von der tatsächlichen Stellung im umgebenden Raum bezeichnet.

Das in Fig. 2 nochmals gesondert dargestellte Einspeisemodul 4 umfasst einen Einspeiseanschluss 34 zur elektrischen Kontaktierung an einen nicht näher dargestellten Hauptstromkreis und somit zur Einspeisung eines elektrischen Stroms in den Stromverteiler 2. Der Einspeiseanschluss 34 ist an der Frontseite 28 des Gehäuses 10 nahe der Oberseite 30 angeordnet, und als eine Anschlussklemme für einen Draht- oder Litzenleiter des Hauptstromkreises ausgestaltet. Der Einspeiseanschluss 34 ist innerhalb des Gehäuses 10 elektrisch leitend mit einem Koppelkontakt 36 gekoppelt, der innerhalb eines nutenartigen Gehäuseschlitzes 38 angeordnet ist.

Das Einspeisemodul 4 weist etwa auf halber Höhe des Gehäuses 10 einen Masseanschluss 40 zur Anbindung an einen Minuspol oder einen Neutralleiter auf. Der Masseanschluss 40 ist an der Frontseite 28 des Gehäuses 10 angeordnet, und als eine Anschlussklemme für einen Draht- oder Litzenleiter ausgestaltet. Der Masseanschluss 40 ist innerhalb des Gehäuses 10 elektrisch leitend mit einer Steckbuchse als Kontaktelement 42, sowie mit einem zweiten Koppelkontakt 44 gekoppelt. Das nachfolgend als Steckbuchse bezeichnete Kontaktelement 42 ist innerhalb einer Gehäuseöffnung 46 an der im Montagezustand einem Anschlussmodul 6 zugewandten Stirnseite 26 nahe der Oberseite 30 angeordnet. Der Koppelkontakt 44 ist in einem mittig am Gehäuse 10 eingebrachten Gehäuseschlitz 48 der Gehäusefrontseite 28 positioniert.

Das Einspeisemodul 4 umfasst weiterhin einen Rückführanschluss 50 zur elektrischen Kontaktierung an eine nicht näher dargestellte Stromrückführung im Zuge einer Schutz- oder Funktionserde. Der Rückführanschluss 50 ist nahe der Unterseite 32 an der Frontseite 28 des Gehäuses 10 angeordnet, und wie der Einspeiseanschluss 34 und Masseanschluss 40 als eine Anschlussklemme ausgeführt. Der Rückführanschluss 50 ist wiederum elektrisch leitend mit einem Koppelkontakt 52 innerhalb eines im Bereich der Unterseite 32 angeordneten Gehäuseschlitzes 54 gekoppelt.

Die nutenartigen Gehäuseschlitze 38, 48, 54 sind insbesondere derart in das Gehäuse 10 des Einspeisemoduls 4 eingebracht, dass sie zu der Gehäusefrontseite 28 hin offen sind. Die Gehäuseschlitze 38, 48, 54 erstrecken sich in Reihenrichtung 22 im Wesentlichen über die gesamte Gehäusebreite und sind somit zu den beiden gegenüberliegenden Stirnseiten 26 des Gehäuses 10 hin offen.

Zwischen dem Einspeiseanschluss 34 und dem Masseanschluss 40 sind gehäusefrontseitig drei weitere Anschlussklemmen für einen Signalanschluss 56 sowie zwei Kommunikationsanschlüssen 58 und 60 vorgesehen. Die Anschlüsse 56, 58, 60 sind im Vergleich zu den Anschlüssen 34, 40, 50 verkleinert ausgeführt, und vorzugsweise für die Einspeisung von Niederströmen als Schalt- beziehungsweise Kommunikationssignale ausgestaltet. Die Anschlüsse 56, 58, 60 sind ähnlich zu dem Masseanschluss 40 innerhalb des Gehäuses 10 mit als Steckbuchsen ausgeführte Kontaktelemente 62, 64, 66 gekoppelt. Die Kontaktelemente oder Steckbuchsen 62, 64, 66 sind von der Stirnseite 26 her mittels etwa rechteckigen Gehäuseöffnungen 68, 70, 72 zugänglich.

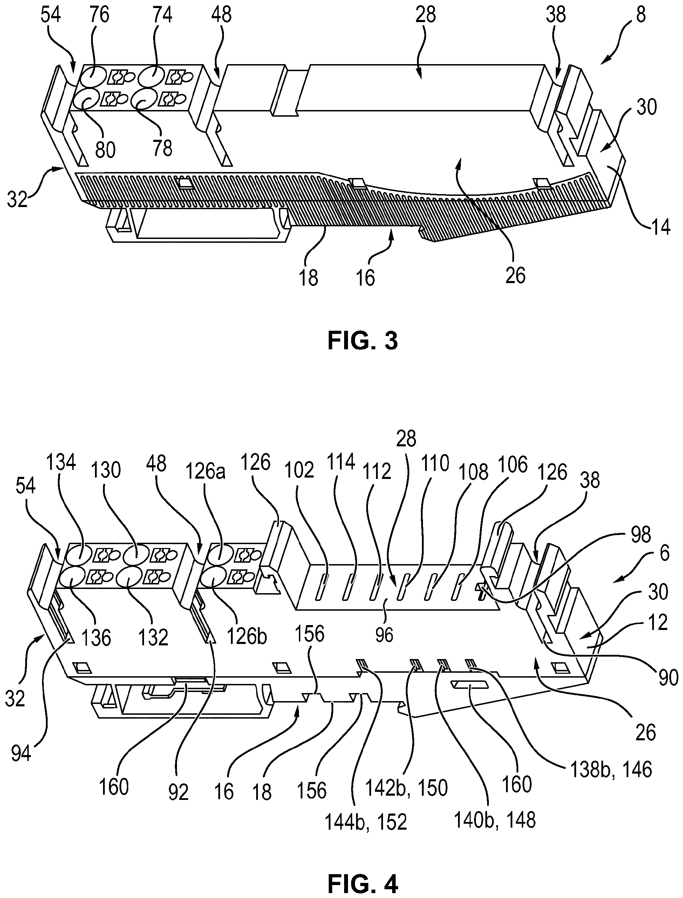

Anhand der Fig. 3 ist im Nachfolgenden das Signalmodul 8 näher erläutert. Das Gehäuse 14 des Signalmoduls 8 weist drei Gehäuseschlitzes 38, 48 und 54 auf, die im Wesentlichen identisch zu denen des Einspeisemoduls 4 ausgestaltet sind, jedoch keine Koppelkontaktierung mit dem Gehäuseinneren aufweisen. Zwischen den unteren Gehäuseschlitzen 48 und 54 sind vier Anschlussklemmen 74, 76, 78 und 80 als ein Masseanschluss 74, ein Signalanschluss 76 sowie zwei Kommunikationsanschlüsse 78 und 80 angeordnet.

Die Anschlüsse 74, 76, 78, 80 sind innerhalb des Gehäuses 14 mit Kontaktelementen 82, 84, 86, 88 elektrisch leitfähig gekoppelt. Die nachfolgend als Stecker bezeichneten Kontaktelemente 82, 84, 86, 88 sind insbesondere als Flachstecker ausgeführt und ragen aus der im Montagezustand einem Anschlussmodul 6 zugewandten Stirnseite 26 zumindest teilweise aus dem Gehäuse 14 heraus. Die Stecker 82, 84, 86, 88 sind hierzu insbesondere derart angeordnet, dass sie im Montagezustand im Wesentlichen auf einer Höhe mit den Steckbuchsen 42, 62, 64, 66 positioniert sind.

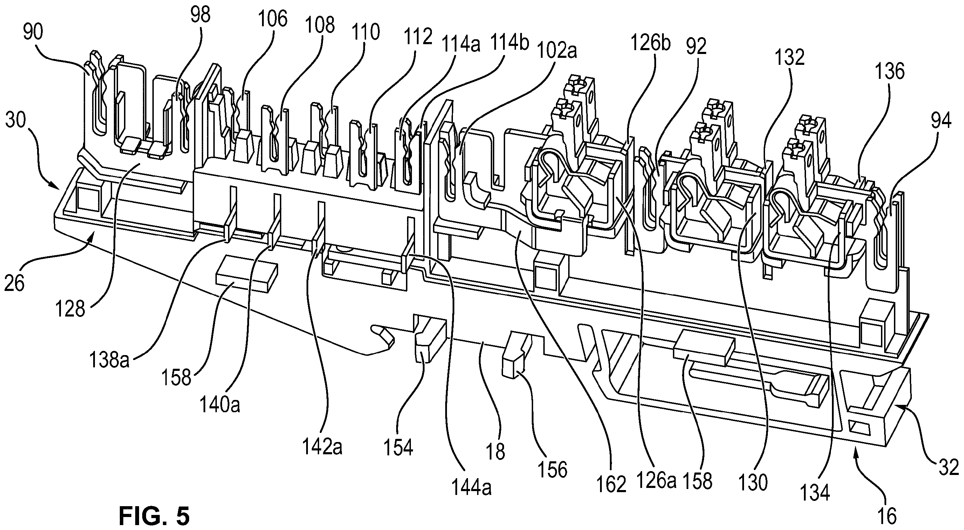

Anhand der Fig. 4 und Fig. 5 ist im Nachfolgenden der Aufbau eines Anschlussmoduls 6 näher erläutert, wobei beispielhaft in Fig. 1 lediglich ein Anschlussmodul 6 mit Bezugszeichen versehen ist. Das Gehäuse 12 des Anschlussmoduls 6 weist drei Gehäuseschlitzes 38, 48 und 54 auf, die im Wesentlichen identisch zu denen des Einspeisemoduls 4 ausgestaltet sind, mit jeweils einem Koppelkontakt 90, 92, 94 im Gehäuseinneren. Zwischen den Gehäuseschlitzen 38 und 48 ist ein gehäusefrontseitiger Steckplatz 96 für den Schutzschalter 24 angebracht. Der Steckplatz 96 weist eine erste Kontaktöffnung 98 für einen (bevorzugt als Flachstecker ausgebildeten) ersten Steckkontakt 100 des Schutzschalters 24 sowie eine zweite Kontaktöffnung 102 für einen (bevorzugt ebenfalls als Flachstecker ausgebildeten) zweiten Steckkontakt 104 des Schutzschalters 24 auf.

Der Steckplatz 96 ist außerdem mit fünf weitere Kontaktöffnungen 106, 108, 110, 112, und 114 für (bevorzugt als Flachkontakte ausgebildete) korrespondierende Signal- oder Kommunikationskontakte 116, 118, 120, 122, und 124 des Schutzschalters 24 versehen. Wie insbesondere in Fig. 5 ersichtlich sind die Kontaktöffnungen 98, 102, 106, 108, 110, 112 und 114 des Steckplatzes 96 insbesondere als Stecksockelkontakte ausgeführt. Die Kontaktöffnungen 98, 102, 106, 108, 110, 112, 114 und die Steck- oder Signalkontakte 100, 104, 116, 118, 120, 122, 124 sind insbesondere im Sinne von Stecker-Buchsen-Paaren zueinander komplementär ausgestaltet.

Der Steckplatz 96 weist weiterhin im oberen und unteren Bereich jeweils ein hakenähnliches Rastelement 126 zur zerstörungsfreien Klemmbefestigung des Schutzschalters 24 auf. Das Gehäuse des Schutzschalters 24 weist zu diesem Zwecke in nicht näher beschriebener Art und Weise ein entsprechendes angeformtes Widerlager oder Hintergriffelement zum Zwecke eines einfachen, rüttelfreien und betriebssicheren Verrastens oder Verklipsens auf.

Unterhalb des Steckplatzes 96 sind zwei Anschlussklemmen als Lastanschlüsse 126a und 126b zum Anschluss eines nicht näher dargestellten Verbraucher- oder Laststromkreises angeordnet. Die Anschlussklemmen 126a, 126b sind gehäuseintern mit der Kontaktöffnung 102 elektrisch leitfähig gekoppelt. Weiterhin ist die Kontaktöffnung 98 im inneren des Gehäuses 12 mit dem Koppelkontakt 90 des Gehäuseschlitzes 38 im Wesentlichen einstückig mittels einer elektrisch leitfähigen Leiterschiene 128 gekoppelt. Somit ist der Schutzschalter 24 im Montagezustand zwischen dem Koppelkontakt 90 und den Lastanschlüssen 126a, 126b zur Unterbrechung des Laststromkreises verschaltet.

Das Anschlussmodul 6 umfasst ferner vier Anschlussklemmen 130, 132, 134 und 136, die zwischen den unteren Gehäuseschlitzen 48 und 54 als zwei Masseanschlüsse 130, 132 und zwei Rückführanschlüsse 134, 136 angeordnet sind. Im Inneren des Gehäuses 12 sind die Masseanschlüsse 130 und 132 an jeweils einen Koppelkontakt 94 des Gehäuseschlitzes 54 und die Rückführanschlüsse 134 und 136 an jeweils einen Koppelkontakt 92 des Gehäuseschlitzes 48 elektrisch leitfähig angebunden.

Die Kontaktöffnungen 106, 108, 110 ,112 und 114 sind gehäuseintern an vier Kontaktelemente 138, 140, 142 und 144 elektrisch leitfähig gekoppelt. Die Kontaktelemente 138, 140, 142 und 144 sind insbesondere als Stecker-Buchsen-Paare ausgeführt, wobei die Stecker im Nachfolgenden den Bezugszeichenzusatz -a und die Buchsen den Bezugszeichenzusatz -b aufweisen. Die Steckbuchsen 138b, 140b, 142b und 144b sind in stirnseitigen Gehäuseöffnungen 146, 148, 150 und 152 angeordnet, wobei die Stecker 138a, 140a, 142a und 144a zumindest teilweise - wie insbesondere in Fig. 5 ersichtlich - aus der gegenüberliegenden Stirnseite 26 des Gehäuses 12 herausragen.

Die Gehäuse 12 und 14 der Anschlussmodule 6 und des Signalmoduls 8 weisen - wie in Fig. 5 deutlich - auf der Gehäuserückseite 16 im Bereich der Aufnahme 18 zwei Rastzungen 154 auf, die der jeweiligen Stirnseite 26 überstehen. Die Rastzungen 154 sind zum Zwecke einer erleichterten Montage der Module 4, 6, 8 mit entsprechenden Rastaufnahmen 156 der Anschlussmodule 6 und des Einspeisemoduls 4 verrast beziehungsweise verklipsbar, wobei die Rastaufnahmen 156 an der den Rastzungen 154 gegenüberliegenden Stirnseite 26 angeordnet sind. Die Gehäuse 12, 14 weisen weiterhin auf der rastzungenseitigen Stirnseite 26 zwei angeformte und der Strinseite 26 überstehende Fügefortsätze 158 zum erleichterten Aneinanderreihen beziehungsweise Aneinanderstecken der Module 4, 6, 8 auf. Die Fügefortsätze 158 greifen im Montagezustand zumindest teilweise in entsprechende Fügeaufnahmen 160 der benachbarten Module 4, 6 zum Zwecke einer rüttelfreien und betriebssicheren Befestigung ein.

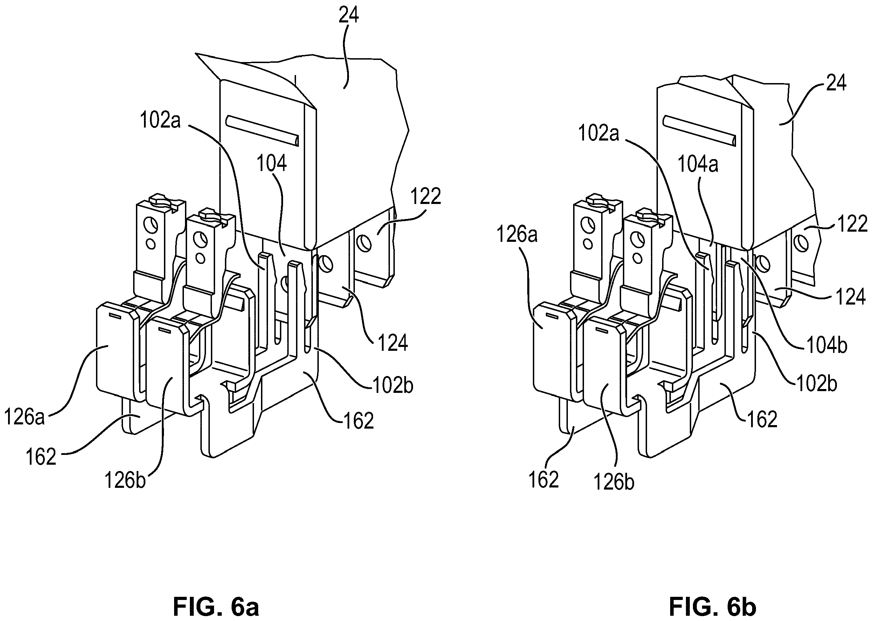

Wie insbesondere in den Figuren 6a und 6b deutlich wird ist die stecksockelartige Kontaktöffnung 102 insbesondere als ein zweifach geteilter Stecksockelkontakt ausgeführt. Die dadurch gebildeten Stecksockelteilkontakte 102a und 102b sind im Wesentlichen einstückig mittels jeweils einer Leiterschiene 162 an die Lastanschlüsse 126a beziehungsweise 126b elektrisch leitfähig gekoppelt. Dadurch ist die Kontaktöffnung 102 dazu geeignet und eingerichtet sowohl einkanalige als auch zweikanalige Schutzschalter aufzunehmen und separat an einen jeweiligen Laststromkreis anzuschließen.

In Fig. 6a ist ausschnittsweise ein mit der Kontaktöffnung 102 kontaktierter einkanaliger Schutzschalter 24 mit dem als einfahniger Flachstecker ausgeführten Steckkontakt 104 dargestellt. In diesem Ausführungsbeispiel kontaktieren beide Stecksockelteilkontakte 102a und 102b mit dem gleichen Steckkontakt, sodass an den Lastausgängen 126a und 126b der gleiche Ausgangsstrom bereitgestellt wird.

Die Kontaktierung mit einem zweikanaligen Schutzschalter 24 zum Anschluss an einen zweikanaligen Laststromkreis ist in Fig. 6b dargestellt. In diesem Ausführungsbeispiel ist der Steckkontakt 104 als ein Flachstecker mit einer zweigeteilten Steckfahne ausgeführt. Hierbei kontaktieren die dadurch gebildeten Steckkontakte 104a und 104b galvanisch getrennt voneinander an die Stecksockelteilkontakte 102a beziehungsweise 102b. Dadurch ist es möglich mit einem Anschlussmodul sowohl einkanalige als auch zweikanalige Schutzschalter 24 und Laststromkreise anzuschließen. Insbesondere ist es dadurch möglich einkanalige und zweikanalige Schutzschalter 24 gleichzeitig in zwei Anschlussmodulen 6 des gleichen Stromverteilers 2 zu betreiben.

Zur Montage des Stromverteilers 2 wird ein Signalmodul 4 mit einer Anzahl an anzuschließenden Laststromkreise entsprechende Zahl von Anschlussmodulen 6 und einem Signalmodul 8 gemäß Fig. 1 stirnseitig aneinandergereiht. Dabei werden die Module 6, 8 durch die Rastzungen 154 an den Stirnseiten 26 jedes Gehäuses 12, 14 mit den entsprechenden Rastaufnahmen 156 der Module 4, 6 an der Stirnseite 26 des jeweils benachbarten Moduls 4, 6, 8 fluchtend und lösbar miteinander (steck-)verbunden. Die Stirnseiten 26 der Anschlussmodule 6 werden somit von dem Einspeisemodul 4, benachbarten Anschlussmodulen 6 sowie dem Signalmodul 8 im Wesentlichen vollständig abgedeckt. Wie insbesondere in Fig. 1 deutlich wird, fluchten die Gehäuseschlitze 38, 48 und 54 der benachbarten Module 4, 6, 8 ineinander, sodass jeweils eine im Wesentlichen durchgängige und geradlinige nutenartige Durchsetzung der Module 4, 6, 8 realisiert ist.

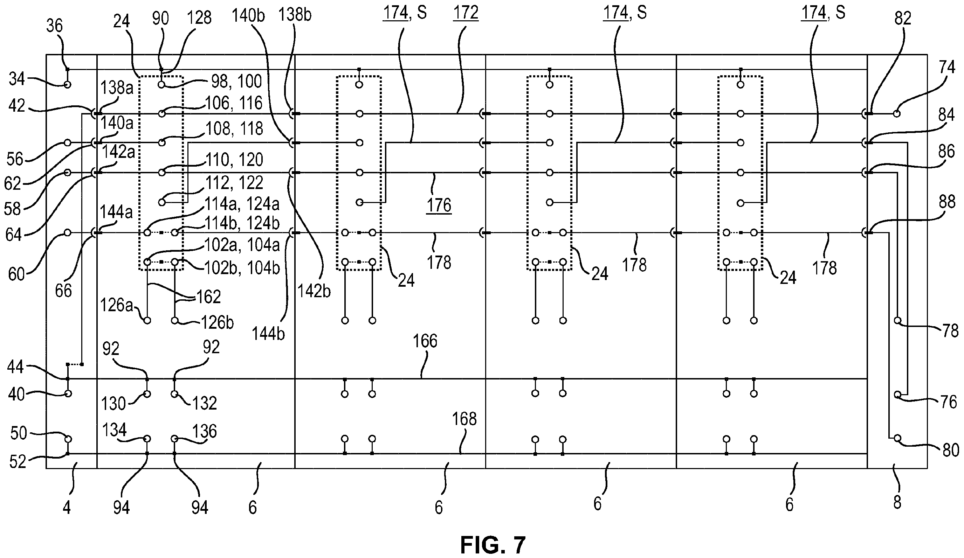

Im Rahmen eines derartigen Stromverteilers 2 wird der Einspeiseanschluss 34 des Einspeisemoduls 4 mit den aneinandergereihten Modulen 4, 6 parallel geschaltet, indem eine Stromschiene 164 - wie in Fig. 7 angedeutet - in die fluchtenden Gehäuseschlitze 38 der Module 4, 6, 8 eingedrückt, und so mit den Koppelkontakten 36, 90 kontaktiert wird. Die Stromsammelschiene 164 ist hierbei hinsichtlich ihrer Länge derart bemessen, dass sie sich über die Gesamtbreite aller in den Stromverteiler 2 zu integrierenden Module 4, 6, 8 erstreckt. Der Anschluss der somit parallel geschalteten Module 4, 6 an eine externe Spannungsquelle erfolgt hierbei durch konventionelle Verdrahtung des Hauptstromkreises mit der Anschlussklemme des Einspeiseanschlusses 34.

Ebenso werden die Massenanschlüsse 40, 130, 132 sowie die Rückführanschlüsse 50, 134, 136 der aneinandergereihten Module 4, 6 durch Eindrücken jeweils einer Stromschiene 166 und 168 in den Gehäuseschlitzen 48 und 54 einander parallel geschaltet, wobei der Masseanschluss 40 insbesondere mit einer Erde, und der Rückführanschluss 50 insbesondere mit einer Schutz- oder Funktionserde als Rückführpotential angeschlossen werden. Die einzelnen Laststromkreise des Stromverteilers 2 werden anschließend an jeweils ein zugeordnetes Anschlussmodul 6 angeschlossen, indem die jeweiligen Zuführleitungen des Laststromkreises mit den Lastanschlüssen 126a und/oder 126b der Anschlussmodule 6, und die Rückführleitung des Laststromkreises mit den Anschlussklemmen der Rückführanschlüsse 134 und/oder 136 der Anschlussmodule 6 elektrisch leitfähig verbunden werden.

Um die Gehäuseschlitze 38, 48, 54 der Module 4, 8 zu den in Reihenrichtung 22 jeweils außenliegenden Stirnseiten 26 berührungssicher abzuschließen, ist jeder Gehäuseschlitz 38, 38, 54 - wie in Fig. 1 für das Einspeisemodul 4 dargestellt - mit einem isolierenden Abdeckelement 170 versehen.

Die resultierende Verschaltung der Module 4, 6, 8 im Montagezustand ist in Fig. 7 beispielhaft für einen Stromverteiler 2 mit vier jeweils mit einem Schutzschalter 24 bestückten Anschlussmodulen 6 dargestellt. In Fig. 7 sind die Anschlüsse des Anschlussmoduls 6 und des Schutzschalters 24 beispielhaft lediglich für ein Anschlussmodul 6 und einen Schutzschalter 24 eingezeichnet.

Über den Einspeiseanschluss 34 des Einspeisemoduls 4 wird der Stromverteiler 2 an eine Hauptstromleitung angeschlossen. Durch den Koppelkontakt 36 wird mittels der Stromschiene 164 von jedem Anschlussmodul 6 ein Laststromkreis mittels der Koppelkontakte 90 abgezweigt. Über die Stromschiene 128 fließt der abgezweigte Laststrom über die Kontaktöffnung 98 und den Steckkontakt 100 in einen nicht näher dargestellten Schutzstromkreis des Schutzschalters 24. Der Schutzstromkreis weist vorzugsweise ein elektronisches Schaltelement zum Unterbrechen des angeschlossenen Laststromkreises im Falle einer Überlast auf. über den gegebenenfalls zweifahnig ausgeführten Steckkontakt 104 und die Kontaktöffnung 102 beziehungsweise den Stecksockelteilkontakten 102a und 102b ist der Schutzschalter mit den Lastanschlüssen 126a und 126b an die Zuführleitung(en) des Laststromkreises angeschlossen. Die Rückführung des Laststromkreises erfolgt mittels des Anschluss an die Rückführungsanschlüsse 134 und/oder 136.

Abschließend werden die Anschlussmodule mit den Schutzschaltern 24 bestückt. Die Schutzschalter 24 sind einfach, zeitsparend und problemlos an den Steckplätzen 96 einsteckbar. Durch die Verrastung oder Verklipsung sind die Schutzschalter 24 weiterhin im Bedarfsfall besonders leicht auszutauschen.

Wie insbesondere in Fig. 7 deutlich wird ist das durch die Module 4, 6, 8 gebildete Paket durch die nach Art einer Stecker-Buchsen-Verbindung gekoppelten Kontaktelemente 42, 62, 64, 66, 82, 84, 86, 88, 138, 140, 142, 144 in Reihenrichtung von Gehäusestirnseite 26 zu Gehäusestirnseite 26 von einer Masseleitung 172, einer Schaltsignalleitung 174, einer ersten Kommunikationsleitung 176 sowie einer zweiten Kommunikationsleitung 178 elektrisch leitfähig vom Einspeisemodul 4 zum Signalmodul 8 hin durchsetzt. Die Masseleitung 172, die Schaltsignalleitung 174 und die Kommunikationsleitungen 176 und 178 sind zueinander sowie bezüglich der Stromschienen 164, 166 und 168 im Wesentlichen parallel verlaufend innerhalb der Gehäuse 10, 12, 14 angeordnet.

Die Masseleitung 172 ist an den Koppelkontakt 44 angebunden und mittels der Steckbuchse 42 des Einspeisemoduls 4 mit dem Stecker 138a des benachbarten Anschlussmoduls 6 gekoppelt. Die Masseleitung 172 setzt sich fort über die Kontaktöffnung 106, an der sie mittels des Signalkontakts 116 vom Schutzschalter 24 als Nullvoltbezugspotential gekoppelt ist. Mittels der Steckbuchse 138b verläuft die Masseleitung 172 in identischer Weise weiter durch die benachbarten Anschlussmodule 6 bis die Steckbuchse 138b des äußersten Anschlussmoduls 6 in dem Stecker 82 des Signalmoduls 8 mündet. Die an den Masseanschluss 40 des Einspeisemoduls 4 angeschlossene Minuspol oder Neutralleiter ist somit auch am Masseanschluss 74 des Signalmoduls 8 abgreifbar. Die durch die Kontaktelemente 42, 138 und 82 gebildete Masseleitung 172 ist somit auf dem gleichen elektrischen Potential wie die im Wesentlichen parallel verlaufende Stromschiene 168.

Die Schaltsignalleitung 174 dient zur Führung eines die Schutzschalter 24 betätigbaren Schaltsignals S, das mittels Signalanschluss 56 des Einspeisemoduls 4 eingespeist wird. Das Schaltsignal S ist beispielsweise ein Strom- oder Spannungssignal einer speicherprogrammierbaren Steuerung (SPS) einer externen Steuereinheit des Stromverteilers 2. Die Signalleitung 174 setzt sich mittels der Steckbuchse 62 und den Stecker 140a fort in das angereihte Anschlussmodul 6. Im Anschlussmodul 6 wird das Schaltsignal S mittels der Kontaktöffnung 108 und den Signalanschluss 118 in den Schutzschalter 24 geleitet. Im Schutzschalter 24 ist die Schaltsignalleitung 174 in nicht näher dargestellter Weise fortgesetzt, und derart mit dem elektronischen Schaltelement des Schutzschalters 24 gekoppelt, dass das Schaltelement mittels des Schaltsignals betätigbar ist. Über den Signalanschluss 122 und die Kontaktöffnung 112 ist die Schaltsignalleitung 174 mit der Steckbuchse 140b verschalten. Mittels der Steckbuchse 140b setzt sich die Schaltsignalleitung 174 identisch durch die angereihten Anschlussmodule 6 fort und endet mit dem Stecker 84 im Signalanschluss 76 des Signalmoduls 8.

Die Kommunikationsleitung 176 dient zur Führung eines Kommunikationssignals D. Das Kommunikationssignal D ist vorzugsweise ein Datenbussignal der externen Steuereinheit für den Stromverteiler 2, sodass das Kommunikationssignal D nachfolgend auch als Datenbussignal und die Kommunikationsleitung 176 als Datenbusleitung bezeichnet werden. Das Datenbussignal D wird mittels des Kommunikations- beziehungsweise Datenbusanschlusses 58 durch das Einspeisemodul 4 eingespeist. Über die Steckbuchse 64 ist der Stecker 142a des benachbarten Anschlussmoduls 6 kontaktiert, an den elektrisch leitfähig die Kontaktöffnung 110 mit dem Signal- beziehungsweise Kommunikationskontakt 120 des Schutzschalters 24 verschaltet ist. Mittels der Steckbuchse 140b sind die benachbarten Anschlussmodule 6, und mit ihnen die Schutzschalter 24, in Reihe verschaltet. Die Datenbusleitung 176 endet mittels der Steckverbindung der Steckbuchse 140b mit dem Stecker 86 des Signalmoduls 8 in dem Kommunikations- beziehungsweise Datenbusanschluss 78.

Die Kommunikationsleitung 178 dient zur Führung eines Kommunikationssignals A. Das Kommunikationssignal A ist vorzugsweise ein Adressbussignal der externen Steuereinheit für den Stromverteiler 2, sodass das Kommunikationssignal A nachfolgend auch als Adressbussignal und die Kommunikationsleitung 178 als Adressbusleitung bezeichnet werden. Das Adressbussignal A wird mittels des Kommunikations- beziehungsweise Adressbusanschlusses 60 in das Einspeisemodul 4 eingespeist. Über die Steckbuchse 66 ist der Stecker 144a des benachbarten Anschlussmoduls 6 kontaktiert, an den elektrisch leitfähig die Kontaktöffnung 114 angeschlossen ist. Die Kontaktöffnung 114 ist mit dem Signal- beziehungsweise Kommunikationskontakt 124 des Schutzschalters 24 verschaltet. Bevorzugterweise ist der in diesem Ausführungsbeispiel zweikanalige Schutzschalter 24 mit einem geteilten Kommunikationskontakt mit den Teilkontakten 124a und 124b an die Adressbusleitung 178 gekoppelt.

In dem in Fig. 7 dargestellten Ausführungsbeispiel ist der Schutzschalter 24 insbesondere zweikanalig ausgeführt, wobei die Kontaktöffnung 114 in ähnlicher Weise zur Kontaktöffnung 102 durch zwei Teilanschlüsse 114a und 114b mit dem zweifahnig ausgestalten Flachstecker des Signalkontakts 124a, 124b kontaktiert ist. Zwischen den Signalkontakten 124a und 124b ist das Adressbussignal A innerhalb des Schutzschalters 24 vorzugsweise mit einer nicht näher dargestellten Schutzschalter-Steuereinheit signaltechnisch gekoppelt. Die Kontaktöffnung 114b ist an den Stecker 144b gekoppelt, sodass die Adressbusleitung 178 von den benachbarten Anschlussmodulen 6 zum Stecker 88 des Signalmoduls 8 durchsetzt. Das Adressbussignal A ist am Signalmodul 8 somit am Kommunikations- beziehungsweise Adressbusanschluss 80 abgreifbar.

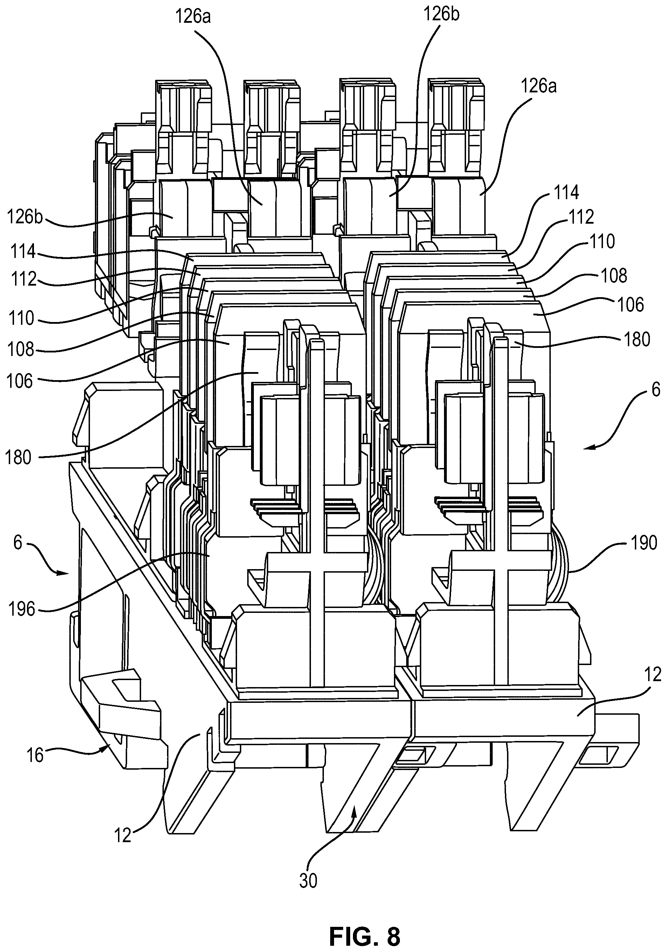

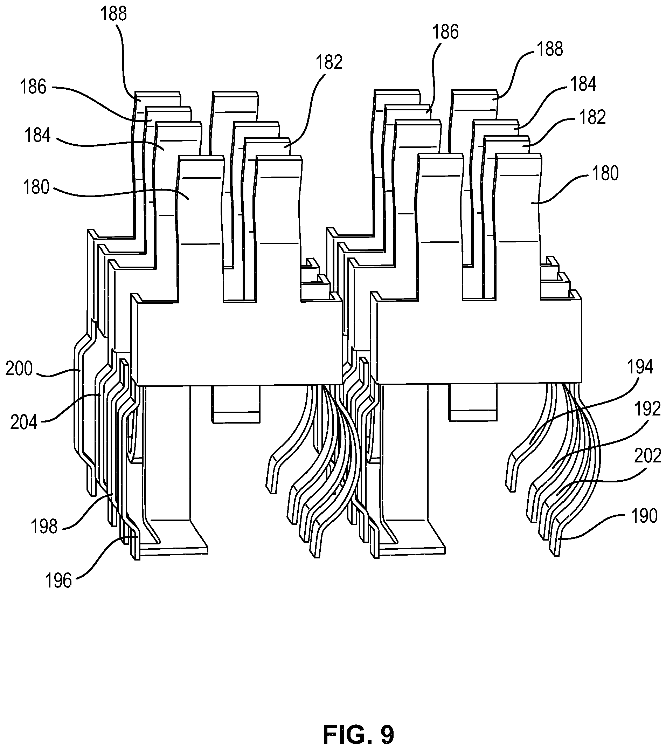

Anhand der Fig. 8 und Fig. 9 ist eine alternative Ausgestaltung der Kontaktelemente 42, 62, 64, 66, 82, 84, 86, 88, 138, 140, 142, 144 zur elektrisch leitfähigen Kontaktierung zwischen den Modulen 4, 6, 8 beispielhaft anhand einer Alternativvariante der Kontaktelemente 138, 140, 142 und 144 näher erläutert.

Die alternativen Kontaktelemente 180, 182, 184, 186 und 188 sind als einstückige Stanzbiegeteile insbesondere als jeweils eine Stecksockelhälfte der Kontaktöffnungen 106, 108, 110, 112 und 114 ausgeführt. Die Kontaktelemente 180, 184 und 188 sind mit je zwei gekoppelten Stecksockellaschen ausgeführt, die zur Gehäuserückseite 16 hin jeweils einen Federbügel 190, 192, 194 und einen Kontaktierbügel 196, 198, 200 aufweisen. Das Kontaktelement 182 weist eine federbogenseitige Stecksockellasche auf, die mit einem Federbügel 202 gekoppelt ist. Das Kontaktelement 186 weist eine hierzu komplementäre kontaktbügelseitige Stecksockellasche auf, die mit einem Kontaktierbügel 204 gekoppelt ist.

Die Federbügel 190, 192, 194 und 202 entsprechen in ihrer kontaktierenden Funktion im Montagezustand den Steckern 138a, 140a, 142a, und 144a der vorangegangenen Ausführungsbeispiele. Entsprechend sind die Kontaktierbügel 196, 198, 204, 200 in diesem Ausführungsbeispiel das elektrisch leitfähig koppelende Äquivalent zu den Steckbuchsen 138b, 140b, 142b, und 144b.

Die Federbügel 190, 192, 194, 202 sind gebogene beigeelastische Elemente, die aus der Stirnseite 26 der Gehäuse 12 zumindest teilweise herausragen, und im Montagezustand in die Gehäuseöffnungen 146, 148, 150, 152 der Stirnseite 26 des benachbarten Gehäuses 12 eingreifen und dort - wie in Fig. 9 dargestellt - kontaktierend zumindest im Bereich ihres Bogenscheitelpunkts an den Kontaktierbügeln 196, 198, 200, 204 anliegen.

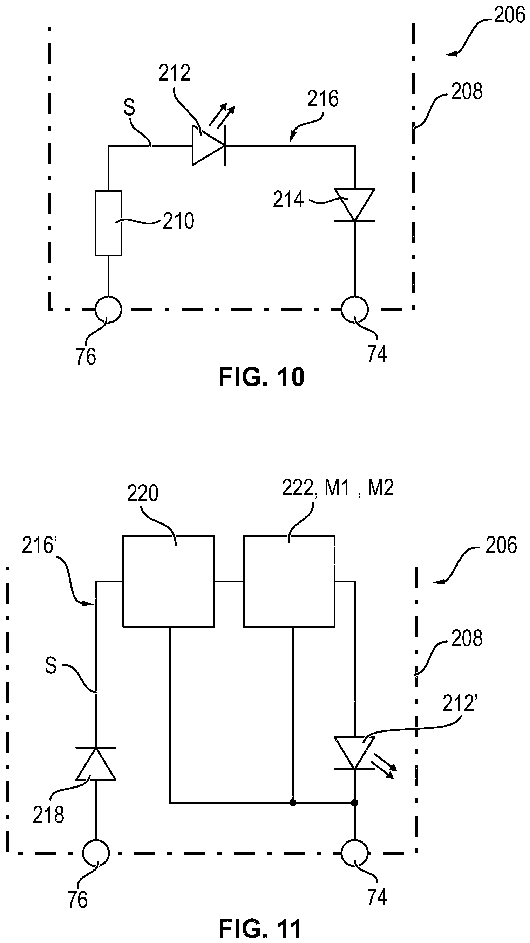

In der Fig. 10 ist ein Anzeigemodul 206 für das Signalmodul 8 schematisch dargestellt. Das Anzeigemodul 206 umfasst ein Gehäuse 208, einen Vorwiderstand 210, eine grüne Anzeige-LED 212 und eine Verpolschutzdiode 214. Der Vorwiderstand 210, die Anzeige-LED 212 und die Verpolschutzdiode 214 sind als eine in Reihe geschaltete Zusatzbeschaltung 216 zwischen dem Signalanschluss 76 und dem Masseanschluss 74 des Signalmoduls 8 elektrisch leitfähig angeordnet. Die Zusatzbeschaltung 216 verstärkt das bevorzugterweise als Stromsignal geleitete Schaltsignal S, und erlaubt es einem Benutzer mittels der Anzeige-LED 212 den Zustand der Schaltsignalleitung 174 optisch zu überwachen. In diesem Ausführungsbeispiel leuchtet die Anzeige-LED 212 beispielsweise im Betrieb grün, und ist aus, falls die Schaltsignalleitung 174 unterbrochen ist.

In der Fig. 11 ist eine zweite Ausführungsvariante des Anzeigemoduls 206 mit einer aktiven Beschaltung dargestellt. Die das Schaltsignal S verstärkende Zusatzbeschaltung 216' weist in dieser Ausführung eine Schutzdiode 218, ein internes Netzteil 220, eine Auswerteeinheit 222 und eine Anzeige-LED 212' auf. Die Schutzdiode 218 ist in Durchlassrichtung zwischen dem Signalanschluss 76 und dem Netzteil 220 angeordnet. Das Netzteil 220 und die Auswerteeinheit 222 sind der in diesem Ausführungsbeispiel als Doppel-LED ausgeführten Anzeige-LED 212' parallel geschaltet.

Die Auswerteeinheit 222 ist in einer geeigneten Ausgestaltung als ein Mikrokontroller ausgeführt, oder alternativ mittels Operationsverstärkern, Komperatoren, ecetera aufgebaut. Die Zusatzbeschaltung 216' dient in diesem Ausführungsbeispiel insbesondere als ein Schaltsignalüberwachungsmodul. Die vorzugsweise grün/rot leuchtende Anzeige- oder Doppel-LED 212' ist dazu geeignet und eingerichtet optisch die vier Zustände AUS, grün, gelb und rot, gegebenenfalls auch blinkend darzustellen. Dadurch sind einem Benutzer besonders viele Informationen über einen mit der Schaltsignalleitung 174 gebildeten Schaltsignalkreis optisch darstellbar. So sind zum Beispiel die drei Farben Rot/Gelb/Grün verschiedenen Betriebszuständen des Schaltsignalkreises zugeordnet, beispielsweise Grün für ein Schaltsignal S mit einem durch die Auswerteeinheit 222 erfassten Messwert der über einem in der Auswerteeinheit hinterlegten ersten Schwellwert M1 liegt, Gelb für ein Schaltsignal S das zwischen dem ersten Schwellwert M1 und einem zweiten Schwellwert M2 ist, Rot für ein Schaltsignal S dessen Wert kleiner als der zweite Schwellwert M2 ist, sowie AUS als optisches Signal dass kein Schaltsignal S vorhanden ist beziehungsweise ein Spannungsausfall oder Drahtbruch der Schaltsignalleitung 174 vorliegt.

In einer geeigneten Dimensionierung für ein spannungsartiges Schaltsignal S ist der Schwellwert M1 beispielsweise 22 V und der Schwellwert M2 20 V. Für ein stromartiges Schaltsignal S sind beispielsweise ein Schwellwert M1 von 10 mA und ein Schwellwert M2 von 5 mA denkbar.

Die zweipoligen Anschlussklemmen der Lastanschlüsse 126a und 126b weisen in einer geeigneten Ausgestaltung jeweils einen Anschlussquerschnitt von etwa 4 mm² auf. Alle Anschlussklemmen der Module 4, 6, 8 sind beispielsweise als Schraubklemmen, Zugfederklemmen oder vorzugsweise als Federkraftklemmen ausgeführt, sodass Draht- oder Litzenleiter rüttelsicher, wartungsfrei und mit einem minimalen Montageaufwand anschließbar sind.

Die Erfindung ist nicht auf die vorstehend beschriebenen Ausführungsbeispiele beschränkt. Vielmehr können auch andere Varianten der Erfindung von dem Fachmann hieraus abgeleitet werden, ohne den Gegenstand der Erfindung zu verlassen. Insbesondere sind ferner alle im Zusammenhang mit den Ausführungsbeispielen beschriebenen Einzelmerkmale auch auf andere Weise miteinander kombinierbar, ohne den Gegenstand der Erfindung zu verlassen.

Insbesondere sind auch Anschlussmodule 6 für den Anschluss an einen dreikanaligen Laststromkreis denkbar. Hierfür sind entsprechend zusätzliche Anschlüsse für die Masse und Rückführung vorgesehen, sowie ein dreigeteilter Stecksockelkontakt der Kontaktöffnung 102, mit entsprechenden drei Lastanschlüssen 126, beispielsweise mit jeweils einem 1.5 mm² flächigen Anschlussquerschnitt. Ferner ist es beispielsweise möglich das Anzeigemodul 206 direkt im Gehäuse 14 des Signalmoduls 8 mit einzubauen. Weiterhin sind auch unterschiedliche Schutzschalter 24 in einzelnen Anschlussmodulen 6 einsteck beziehungsweise montierbar.

### Bezugszeichenliste

- 2: Stromverteiler
- 4: Einspeisemodul
- 6: Anschlussmodul
- 8: Signalmodul
- 10: Gehäuse
- 12: Gehäuse
- 14: Gehäuse
- 16: Gehäuserückseite
- 18: Aufnahme
- 20: Tragschiene
- 22: Reihenrichtung
- 24: Schutzschalter
- 26: Stirnseite
- 28: Frontseite
- 30: Oberseite
- 32: Unterseite
- 34: Einspeiseanschluss
- 36: Koppelkontakt
- 38: Gehäuseschlitz
- 40: Masseanschluss
- 42: Kontaktelement/Steckbuchse
- 44: Koppelkontakt
- 46: Gehäuseöffnung
- 48: Gehäuseschlitz
- 50: Rückführanschluss
- 52: Koppelkontakt
- 54: Gehäuseschlitz
- 56: Signalanschluss
- 58: Kommunikations-/Datenbusanschluss
- 60: Kommunikations-/Adressbusanschluss
- 62: Kontaktelement/Steckbuchse
- 64: Kontaktelement/Steckbuchse
- 66: Kontaktelement/Steckbuchse
- 68: Gehäuseöffnung
- 70: Gehäuseöffnung
- 72: Gehäuseöffnung
- 74: Masseanschluss
- 76: Signalanschluss
- 78: Kommunikations-/Datenbusanschluss
- 80: Kommunikations-/Adressbusanschluss
- 82: Kontaktelement/Stecker
- 84: Kontaktelement/Stecker
- 86: Kontaktelement/Stecker
- 88: Kontaktelement/Stecker
- 90: Koppelkontakt
- 92: Koppelkontakt
- 94: Koppelkontakt
- 96: Steckplatz
- 98: Kontaktöffnung
- 100: Steckkontakt
- 102: Kontaktöffnung
- 102a, 102b: Stecksockelteilkontakt
- 104, 104a, 104b: Steckkontakt
- 106: Kontaktöffnung
- 108: Kontaktöffnung
- 110: Kontaktöffnung
- 112: Kontaktöffnung
- 114, 114a, 114b: Kontaktöffnung
- 116: Signalkontakt
- 118: Signalkontakt
- 120: Signal-/Kommunikationskontakt
- 122: Signalkontakt
- 124, 124a, 124b: Signal-/Kommunikationskontakt
- 126, 126a, 126b: Lastanschluss
- 128: Leiterschiene
- 130: Masseanschluss
- 132: Masseanschluss
- 134: Rückführanschluss
- 136: Rückführanschluss
- 138: Kontaktelement
- 138a: Stecker
- 138b: Steckbuchse
- 140: Kontaktelement
- 140a: Stecker
- 140b: Steckbuchse
- 142: Kontaktelement
- 142a: Stecker
- 142b: Steckbuchse
- 144: Kontaktelement
- 144a: Stecker
- 144b: Steckbuchse
- 146: Gehäuseöffnung
- 148: Gehäuseöffnung
- 150: Gehäuseöffnung
- 152: Gehäuseöffnung
- 154: Rastzunge
- 156: Rastaufnahme
- 158: Fügefortsatz
- 160: Fügeaufnahme
- 162: Leiterschiene
- 164: Stromschiene
- 166: Stromschiene
- 168: Stromschiene
- 170: Abdeckelement
- 172: Masseleitung
- 174: Schaltsignalleitung
- 176: Kommunikations-/Datenbusleitung
- 178: Kommunikations-/Adressbusleitung
- 180: Kontaktelement
- 182: Kontaktelement
- 184: Kontaktelement
- 186: Kontaktelement
- 188: Kontaktelement
- 190: Federbügel
- 192: Federbügel
- 194: Federbügel
- 196: Kontaktierbügel
- 198: Kontaktierbügel
- 200: Kontaktierbügel
- 202: Federbügel
- 204: Kontaktierbügel
- 206: Anzeigemodul
- 208: Gehäuse
- 210: Vorwiderstand
- 212: Anzeige-LED
- 212': Anzeige-LED/Doppel-LED
- 214: Verpolschutzdiode
- 216,216': Zusatzbeschaltung
- 218: Schutzdiode
- 220: Netzteil
- 222: Auswerteeinheit

- S: Schaltsignal
- D: Kommunikations-/Datenbussignal
- A: Kommunikations-/Adressbussignal
- M1: Schwellwert
- M2: Schwellwert

## Patentansprüche

1. Stromverteiler (2) mit einer Anzahl von aneinandergereihten Stromverteilungsmodulen (4, 6, 8), mit einem stirnseitig angeordneten Einspeisemodul (4) und mit einem gegenüberliegend angeordneten Signalmodul (8) sowie mit mindestens einem dazwischen angeordneten Anschlussmodul (6),
- wobei das Einspeisemodul (4) einen Einspeiseanschluss (34) für eine Hauptstromleitung zum Abgreifen eines Einspeisestroms aufweist,
- wobei das Anschlussmodul (6) mit einem betätigbaren Schutzschalter (24) bestückt oder bestückbar ist und eine Anzahl von Lastanschlüssen (126a, 126b) zum Anschluss an einen mittels des Schutzschalters (24) unterbrechbaren Laststromkreis aufweist,
- wobei das Signalmodul (8) einen ersten Signalanschluss (76) für ein den Schutzschalter (24) betätigendes Schaltsignal (S) aufweist, und
- wobei die Stromverteilungsmodule (4, 6, 8) untereinander elektrisch leitfähig gekoppelt oder koppelbar sind
**dadurch gekennzeichnet,**
**dass** die Stromverteilungsmodule (4, 6, 8) zur direkten Montage auf einer Tragschiene (20) ausgeführt sind, und dass zur Führung eines Kommunikationssignals (D, A) eine durch die Stromverteilungsmodule (4, 6, 8) gebildete Kommunikationsleitung (176, 178) bereitgestellt ist,
- wobei das Einspeisemodul (4) einen ersten Kommunikationsanschluss (58, 60) für die Einspeisung des Kommunikationssignals (D, A) aufweist,
- wobei das Anschlussmodul (6) elektrisch leitfähig an einen Kommunikationskontakt (120, 124) des Schutzschalters (24) gekoppelt ist,
- wobei die Schutzschalter (24) mehrerer aneinander gereihter Anschlussmodule bezüglich des Kommunikationskontakts (120, 124) in Reihe geschalten sind,
- wobei das Signalmodul (8) einen zweiten Kommunikationsanschluss (78, 80) für das Abgreifen des Kommunikationssignals (D, A) aufweist, und
- wobei die Stromverteilungsmodule (4, 6, 8) untereinander in einer Reihenrichtung (22) mittels zweiten Kontaktelementen (64, 66, 86, 88, 142, 144, 184, 188) von Gehäusestirnseite zu Gehäusestirnseite elektrisch leitfähig querverdrahtet sind.

2. Stromverteiler (2) nach Anspruch 1,
**dadurch gekennzeichnet,**
**dass** das Einspeisemodul (4) und das Anschlussmodul (6) jeweils
- einen Einspeisungsanschluss zur Zuführung des Einspeisestroms mit einem ersten Koppelkontakt (36, 90),
- einen Masseanschluss mit einem zweiten Koppelkontakt (44, 92), und
- einen Rückführanschluss zur Rückführung des Einspeisestroms mit einem dritten Koppelkontakt (52, 94),
umfassen, wobei die Koppelkontakte (36, 44, 52, 90, 92, 94) in einem jeweils zugeordneten Gehäuseschlitz (38, 48, 54) an einer Gehäusefrontseite (28) angeordnet sind, der ein Gehäuse (10, 12) des jeweiligen Moduls (4, 6) in Reihenrichtung (22) vollständig durchsetzt.

3. Stromverteiler (2) nach Anspruch 1 oder 2,
**dadurch gekennzeichnet,**
**dass** zur Führung des Schaltsignals (S) eine durch die Stromverteilungsmodule (4, 6, 8) gebildete Schaltsignalleitung (174) bereitgestellt ist,
- wobei das Einspeisemodul (4) einen zweiten Signalanschluss (56) für die Einspeisung des Schaltsignals (S) aufweist,
- wobei das Anschlussmodul (6) elektrisch leitfähig an zwei Signalkontakte (116, 120) des Schutzschalters (24) gekoppelt ist,
- wobei die Schutzschalter (24) mehrerer aneinander gereihter Anschlussmodule (6) bezüglich der Signalkontakte (116, 120) in Reihe geschalten sind,
- wobei das Schaltsignal (S) an dem ersten Signalanschluss (76) des Signalmoduls (8) abgreifbar ist, und
- wobei die Stromverteilungsmodule (4, 6, 8) gehäusestirnseitig in Reihenrichtung (22) mittels ersten Kontaktelementen (62, 140, 84, 182, 186) elektrisch leitfähig gekoppelt sind.

4. Stromverteiler (2) nach einem der Ansprüche 1 bis 3,
**dadurch gekennzeichnet,**
**dass** die Kontaktelemente (182, 184, 186, 188) einen Federbügelkontakt (198, 204, 200) aufweisen, der gehäusestirnseitig aus dem Gehäuse (6, 8) herausragt und im Montagezustand in ein benachbartes Gehäuse (4, 6) zumindest teilweise eingreift und mit einem Kontaktierbügels (202, 192, 194) des benachbarten Kontaktelements (182, 184, 186, 188) elektrisch leitfähig koppelt.

5. Stromverteiler (2) nach einem der Ansprüche 1 bis 4,
**dadurch gekennzeichnet,**
**dass** das Anschlussmodul (6) eine lastausgangsseitige Kontaktöffnung (102) für einen Steckkontakt (104) des Schutzschalters (24) aufweist,
- wobei die Kontaktöffnung (104) als ein mehrfach geteilter Stecksockelkontakt ausgeführt ist,
- wobei die dadurch gebildeten Stecksockelteilkontakte (104a, 104b) galvanisch voneinander getrennt sind, und
- wobei jeder Stecksockelteilkontakt (104a, 104b) an einen separaten Lastanschluss (126a, 126b) gekoppelt ist.

6. Stromverteiler (2) nach einem der Ansprüche 1 bis 5,
**dadurch gekennzeichnet,**
**dass** ein Anzeigemodul (206) zur optischen Überwachung der Schaltsignalleitung (174) an das Signalmodul anschließbar ist.

7. Stromverteiler (2) nach Anspruch 6,
**dadurch gekennzeichnet,**
**dass** das Anzeigemodul (206) eine Anzeige-LED (212, 212') sowie eine das Schaltsignal (S) verstärkende Zusatzbeschaltung (216, 216') aufweist.

8. Stromverteiler (2) nach Anspruch 7,
**dadurch gekennzeichnet,**
**dass** die Zusatzbeschaltung (216') ein internes Netzteil (220) als Spannungsversorgung und eine elektronische Auswerteeinheit (222) aufweist, und wobei die Anzeige-LED (212') insbesondere eine Doppel-LED ist.

## Claims

1. Power distributor (2) with a number of lined up power distribution modules (4, 6, 8), with a feed module (4) arranged at front end and with an oppositely arranged signal module (8) and with at least one connection module (6) arranged therebetween,
- wherein the feed module (4) comprises a feed connection (34) for a main power line for tapping a feed current,
- wherein the connection module (6) is or can be equipped with an actuable circuit breaker (24) and comprises a number of load terminals (126a, 126b) for connection to a load circuit that is interruptable by means of the circuit breaker (24),
- wherein the signal module (8) comprises a first signal connection (76) for a circuit breaker (24) actuated switching signal (S), and
- wherein the power distribution modules (4, 6, 8) are electrically conductively coupled to each other or can be coupled
**characterized in**
**that** the power distribution modules (4, 6, 8) are designed for direct mounting on a support rail (20), and that a communication line (176, 178) formed by the power distribution modules (4, 6, 8) is provided for carrying a communication signal (D, A),
- wherein the feed module (4) comprises a first communication port (58, 60) for feeding the communication signal (D, A),
- wherein the connection module (6) is electrically conductively coupled to a communication contact (120, 124) of the circuit breaker (24),
- wherein the circuit breakers (24) of several lined up connection modules are connected in series with respect to the communication contact (120, 124),
- wherein the signal module (8) comprises a second communication port (78, 80) for tapping the communication signal (D, A), and
- wherein the power distribution modules (4, 6, 8) are cross-wired among each other in a row direction (22) in an electrically conductive manner by means of second contact elements (64, 66, 86, 88, 142, 144, 184, 188) from housing end face to housing end face.

2. Power distributor (2) according to claim 1,
**characterized in**
**that** the feed module (4) and the connection module (6) respectively comprise
- a feed connection for feeding the feed current with a first coupling contact (36, 90),
- a ground terminal with a second coupling contact (44, 92), and
- a return connection for returning of the feed current with a third coupling contact (52, 94),
wherein the coupling contacts (36, 44, 52, 90, 92, 94) are arranged in a respectively associated housing slot (38, 48, 54) on a housing front side (28), said slot completely penetrating a housing (10, 12) of the respective module (4, 6) in the row direction (22).

3. Power distributor (2) according to claim 1 or 2,
**characterized in**
**that** for carrying the switching signal (S) a switching signal line (174) formed by the power distribution modules (4, 6, 8) is provided,
- wherein the feed module (4) comprises a second signal terminal (56) for feeding the switching signal (S),
- wherein the connection module (6) is electrically conductively coupled to two signal contacts (116, 120) of the circuit breaker (24),
- wherein the circuit breakers (24) of several lined up connection modules (6) are connected in series with respect to the signal contacts (116, 120),
- wherein the switching signal (S) can be tapped at the first signal connection (76) of the signal module (8), and
- wherein the power distribution modules (4, 6, 8) at the housing end face in the row direction (22) are electrically conductively coupled by means of first contact elements (62, 140, 84, 182, 186).

4. Power distributor (2) according to one of claims 1 to 3,
**characterized in**
**that** the contact elements (182, 184, 186, 188) have a spring clip contact (198, 204, 200), which projects from the housing (6, 8) at the housing end face and, in the assembled state, at least partially engages in an adjacent housing (4, 6) and electrically conductively couples with a contacting clip (202, 192, 194) of the adjacent contact element (182, 184, 186, 188).

5. Power distributor (2) according to one of claims 1 to 4,
**characterized in**
**that** the connection module (6) comprises a load output-side contact opening (102) for a plug contact (104) of the circuit breaker (24),
- wherein the contact opening (104) is designed as a multiply divided plug socket contact,
- wherein the plug socket part contacts (104a, 104b) formed thereby are galvanically isolated from each other, and
- wherein each plug socket part contact (104a, 104b) is coupled to a separate load terminal (126a, 126b).

6. Power distributor (2) according to any one of claims 1 to 5,
**characterized in**
**that** a display module (206) for optically monitoring the switching signal line (174) can be connected to the signal module.

7. Power distributor (2) according to claim 6,
**characterized in**
**that** the display module (206) comprises a display LED (212, 212') and an additional circuit (216, 216') which amplifies the switching signal (S).

8. Power distributor (2) according to claim 7,
**characterized in**
**that** the additional circuit (216') comprises an internal power supply unit (220) as voltage supply and an electronic evaluation unit (222), and wherein the display LED (212') is in particular a double LED.

## Revendications

1. Distributeur de courant (2) avec un certain nombre de modules de distribution de courant (4, 6, 8) alignés les uns à côté des autres, avec un module d'alimentation (4) disposé sur une face frontale et avec un module de signal (8) disposé à l'opposé, et avec au moins un module de connexion (6) disposé entre lesdits modules,
- dans lequel le module d'alimentation (4) comporte une borne d'alimentation (34) pour une ligne électrique principale permettant de prélever un courant d'alimentation,
- dans lequel le module de connexion (6) est ou peut être équipé d'un disjoncteur de protection actionnable (24) et comporte un certain nombre de bornes de charge (126a, 126b) pour la connexion à un circuit de courant de charge interruptible au moyen du disjoncteur de protection (24),
- dans lequel le module de signal (8) comporte une première connexion de signal (76) pour un signal de commutation (S) actionnant le disjoncteur de protection (24), et
- dans lequel les modules de distribution de courant (4, 6, 8) sont reliés entre eux de façon électriquement conductrice ou peuvent être couplés **caractérisé en ce**
**que** les modules de distribution de courant (4, 6, 8) sont conçus pour être montés directement sur un rail de support (20), et qu'une ligne de communication (176, 178) formée par les modules de distribution de courant (4, 6, 8) est prévue pour acheminer un signal de communication (D, A),
- dans lequel le module d'alimentation (4) comporte un premier port de communication (58, 60) pour alimenter le signal de communication (D, A),
- dans lequel le module de connexion (6) est couplé de manière électriquement conductrice à un contact de communication (120, 124) du disjoncteur de protection (24),
- dans lequel les disjoncteurs de protection (24) d'une pluralité de modules de connexion alignés les uns à côté des autres sont connectés en série par rapport au contact de communication (120, 124),
- dans lequel le module de signal (8) comporte un deuxième port de communication (78, 80) permettant de prélever le signal de communication (D, A), et
- dans lequel les modules de distribution de courant (4, 6, 8) sont câblés transversalement les uns par rapport aux autres de manière électriquement conductrice dans le sens de la rangée (22) au moyen de deuxièmes éléments de contact (64, 66, 86, 88, 142, 144, 184, 188) d'une face frontale du boîtier à l'autre.

2. Distributeur de courant (2) selon la revendication 1,
**caractérisé en ce**
**que** le module d'alimentation (4) et le module de connexion (6) comportent respectivement
- un raccord d'alimentation pour l'alimentation du courant d'alimentation avec un premier contact de couplage (36, 90),
- une borne d'alimentation avec un deuxième contact de couplage (44, 92), et
- une connexion de retour pour le retour du courant d'alimentation avec un troisième contact de couplage (52, 94),
dans lequel les contacts de couplage (36, 44, 52, 90, 92, 94) sont disposés dans une fente de boîtier (38, 48, 54) respectivement associée sur une face frontale du boîtier (28), ladite fente pénétrant complètement dans un boîtier (10, 12) du module respectif (4, 6) dans la direction de la rangée (22).

3. Distributeur de courant (2) selon la revendication 1 ou 2,
**caractérisé en ce**
**qu'**une ligne de signal de commutation (174) formée par les modules de distribution de courant (4, 6, 8) est prévue pour acheminer le signal de commutation (S),
- dans lequel le module d'alimentation (4) comporte une deuxième borne de signal (56) pour l'alimentation du signal de commutation (S),
- dans lequel le module de connexion (6) est couplé de manière électriquement conductrice à deux contacts de signal (116, 120) du disjoncteur de protection (24),
- dans lequel les disjoncteurs de protection (24) d'une pluralité de modules de connexion (6) alignés les uns à côté des autres sont connectés en série par rapport aux contacts de signal (116, 120),
- dans lequel le signal de commutation (S) peut être prélevé à la première connexion de signal (76) du module de signal (8), et
- dans lequel les modules de distribution de courant (4, 6, 8) sont couplés de manière électriquement conductrice sur la face frontale du boîtier dans le sens de la rangée (22) au moyen de premiers éléments de contact (62, 140, 84, 182, 186).

4. Distributeur de courant (2) selon l'une des revendications 1 à 3,
**caractérisé en ce**
**que** les éléments de contact (182, 184, 186, 188) comportent un contact à étrier de ressort (198, 204, 200) qui dépasse du boîtier (6, 8) sur la face frontale du boîtier et, dans l'état monté, s'engage au moins partiellement dans un boîtier adjacent (4, 6) et s'accouple de manière électriquement conductrice à un étrier de contact (202, 192, 194) de l'élément de contact adjacent (182, 184, 186, 188).

5. Distributeur de courant (2) selon l'une des revendications 1 à 4,
**caractérisé en ce**
**que** le module de connexion (6) comporte une ouverture de contact (102) du côté de la sortie de charge pour un contact enfichable (104) du disjoncteur de protection (24),
- dans lequel l'ouverture de contact (104) est conçue comme un contact à socle d'enfichage multi-divisé
- dans lequel les contacts à socle d'enfichage partiels (104a, 104b) ainsi formés sont isolés galvaniquement les uns des autres, et
- dans lequel chaque contact à socle d'enfichage partiel (104a, 104b) est couplé à une borne de charge séparée (126a, 126b).

6. Distributeur de courant (2) selon l'une des revendications 1 à 5,
**caractérisé en ce**
**qu'**un module d'affichage (206) pour la surveillance optique de la ligne de signal de commutation (174) peut être connecté au module de signal.

7. Distributeur de courant (2) selon la revendication 6,
**caractérisé en ce**
**que** le module d'affichage (206) comporte une LED d'affichage (212, 212') et un circuit supplémentaire (216, 216') qui amplifie le signal de commutation (S).

8. Distributeur de courant (2) selon la revendication 7,
**caractérisé en ce**
**que** le circuit supplémentaire (216') comporte un bloc d'alimentation interne (220) comme alimentation en tension et une unité d'évaluation électronique (222), et dans lequel la LED d'affichage (212') est en particulier une LED double.
